**Europäisches Patentamt**

**European Patent Office**

**Office européen des brevets**

(19)

(11) Publication number: **0 005 128**
**A2**

(12) # EUROPEAN PATENT APPLICATION

(21) Application number: **79830009.1**

(22) Date of filing: **11.04.79**

(51) Int. Cl.²: **H 03 J 3/16**
**H 03 J 3/18, H 03 H 7/10**

(30) Priority: **18.04.78 IT 4894678**

(43) Date of publication of application:
**31.10.79 Bulletin 79/22**

(84) Designated Contracting States:
**BE DE FR GB NL**

(71) Applicant: **SELENIA INDUSTRIE ELETTRONICHE
ASSOCIATE S.p.A.
Via Tiburtina, KM 12.4 .
I-00131 Roma(IT)**

(72) Inventor: **Masdea, Arturo
Via Zuccoli, 17
I-00139 Roma(IT)**

(72) Inventor: **Quagliariello, Giuseppe
Via Mario Lizzani 16
I-00169 Roma(IT)**

(54) Improvement in circuits for the automatic tuning of voltage controlled filters.

(57) This invention relates to an improvement in circuits for the automatic tuning of voltage controlled filters, using digital phase control.

*Fig. 1*

EP 0 005 128 A2

1 .

"Improvement in circuits for the automatic tuning of voltage controlled filters".

## DESCRIPTION

o o o o o o o o o o o

This invention relates to an improvement in circuits for the automatic tuning of voltage controlled filters, using digital phase control.

In particular this invention relates to a digital circuitry capable of automatically tuning a voltage controlled filter (e. g. a YIG type filter on a Varicap filter) to a given frequency or to a frequency displaced from this by an amount $\Delta$ F selectable as desired, maintaining the tuning for an indefinite period.

This invention will now be described in its form of realization at present preferred, given as an illustrative but not limiting claim, with reference to the attached figures listed below :

Figure 1 shows the general block diagram of the circuit for this invention.

Figure 2 shows the waveforms illustrating the operation of the circuit of figure 1.

0005128

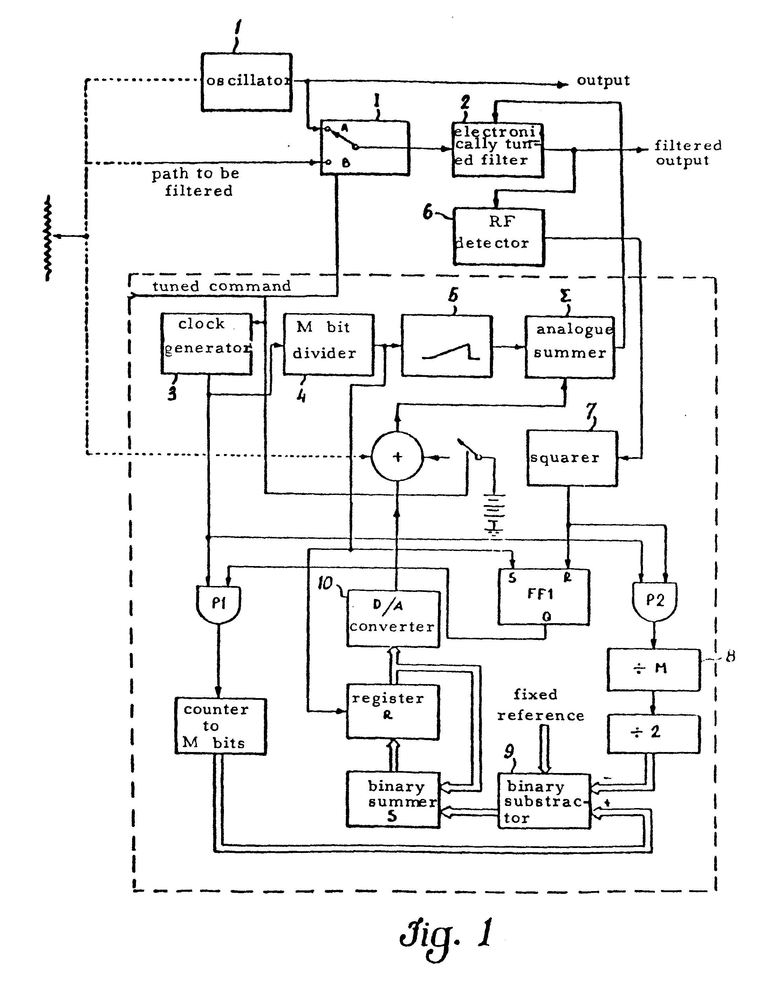

Referring to Figure 1 the part enclosed by the dotted line forms the subject of this invention, while the oscillator 1, switch I, filter 2 and the r.f. detector 6 are conventional devices whose characteristics depend on the operating frequencies.

In particular these is an oscillator 1 which generates a certain frequency such as that of a superheterodyne local oscillator, with the load formed by a mixer and a filter path such as for example the front-end of a receiver, which must be filtered at a frequency which usually must have a certain $\Delta F$ with respect to the frequency produced by oscillator 1.

The operation of the circuit is as follows.

In the tuning search phase the operator operates the "tuning command" maintaining the switch I in position A where it causes the oscillation produced by oscillator 1 to pass through filter 2. Simultaneously the clock generator is enabled and this generates a square wave at a frequency that can range from a few KHz up to tens to KHz and which depends on the speed of variation of the tuning of the filter and the quantization error desired on the tuning.

The clock generator frequency is divided by an M bit divider, 4, to obtain a square wave at a relatively low frequency. This signal has a triple function at the output of divider 4.

a) commands the generation of a low frequency sawtooth in circuit 5, which passing through the analogue adder explores the characteristic of the filter in an interval $\Delta$ f1 chosen in relation to the frequency range within which it is desired to tune            : this range is determined by the amplitude of the sawtooth signal and is adjustable by means not shown.

b) causes the bistable FF1 to produce a high level at the output Q so as to enable the gate P1 allowing the clock pulses to pass .

c) feeds a memorizing signal to the register R.

The exploration of the filter characteristic, controlled by the sawtooth waveform sothat the oscillator 1 frequency is periodically fed to it, so that at the output of the r.f. detector 6 connected to the output of filter 2, there will be a pulses waveform having the same behaviour as the pass band of the filter whose duration is proportioned to the velocity of the sawtooth waveform which controls the tuning of the filter and the delay of which with respect to the start of the sawtooth waveform depends on the tuning of filter 2 with respect to the frequency of oscilla-

tion of oscillator 1. More precisely when filter 2 is centred with res pect

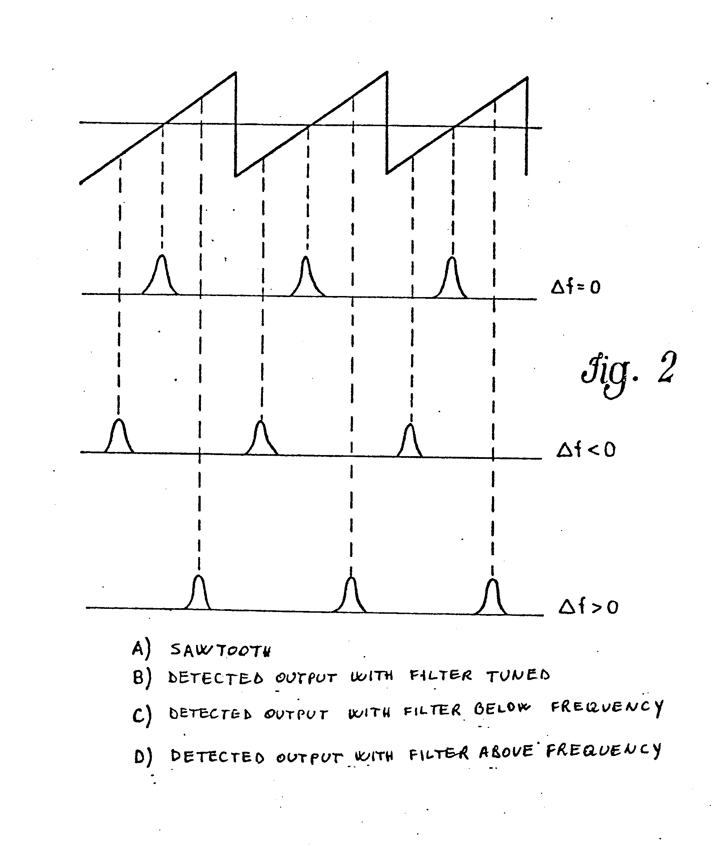

to oscillator 1, the delay is equal to half a sawtooth period, while the delay is less than this if the filter is tuned below, and is more if the filter is tuned above . There conditions are shown in Figure 2 in which A indicates the sawtooth waveform, B indicates the time response of the filter tuned to the oscillator frequency, and C and D indicate respectively the tuning of the filter with $\Delta$ f negative and ppsitive.

The output of the r.f. detector 6 is squared in the squarer 7 and

4                                    0005128

the bistable FFl is reseted to the leading edge of this square wave.

The bistable FFI output A goes to logic O inhibiting gate Pl   and

stopping the clock pulses to the M-bit counter. In this way the M-bit counter acts as a delay reader, i.e. as a phase discriminator.

It should be noted that the square wave coming from the squarer 7 has a certain pulse width which depends on the characteristic of filter 2.

In order to avoid the error introduced by the width of the shaped square wave coming from squarer 6, there is a second circuit gate P2, a second counter 8 which counts up to M bits and this is followed by a divide-by-two stage which  measures the width of the square wave (the division by M bits and the subsequent division by 2 is necessary since it is desired to centre the filter with respect to the oscillation of oscil lator 2 ).

The numerical word corresponding to such a width, divided by two, is subtracted in the binary subtraction circuit 9 from the tuning error to obtain a correct centering of the filter response.

The error is referred to the centering position equal to half the above-mentioned delay.

The error thus corrected is integrated by a digital integration cir cuit formed by the register R and the binary summer S. The accumulated data are fed to the digital-to-analogue converter, 10 which transforms them to an analogue voltage.

This voltage is fed to the analogue summing node N whose output

5

0005128

is in turn fed to the previously mentioned analogue summer

In the summing node N a frequency off-set voltage Vo can be summed after the locking loop has been effected to take into account a prefixed off-tuning of filter 2 with respect to the oscillator.

When the tuning search phase is finished, the switch I is set to the main path.B and the register maintanins the voltage value to be fumished to the filter indefinitively in memory until such time as there is a new value from another "tuning command".

There are possible variations with respect to what has been previously described, e.q.:

a) Oscillator 1 is a VCO (voltage controlled oscillator) and there is a coarse setting of the tuning.

b) Oscillator I is a VCO and the automatic control of the tuning is performed by the oscillator itself rather than on the filter.

c) The use of the previously described circuit as linearizer of the oscillator characteristics with respect to those of the filter (for example in the case of the use of a highly linear YIG filter.

d) Periodic automatic insertion of the tuning signal to correct the characteristics of the oscillator and/or filter in the case of thermic drifting.

These invention has been described in its form of realization at present preferred, given as an illustrative but not limiting clain, and it will be understood that in practice variations and modifications can

6 ‹

0005128

be made to it without taking it outside the present industrial patents

rights.

## CLAIMS

1. Automatic tuning circuit for voltage controlled filters, by means of digital phase control, comprising an oscillator and a filter path associated with the said voltage controlled filter, the said voltage controlled filter having to be adjusted to a frequency equal to that of the said oscillator, or displaced from it by a prefixed amount, and characterized by the inclusion of a means of exploring the characteristic of the said filter while it is being fed by the signal of the said oscillator, means of detecting the displacement (positive or negative) of the response charactestics of the said filter with respect to the frequency of the said oscillator, means of measuring the said displacement digitally and capable of furnishing a signal for the correction of the characteristic of the said filter, and means of memorizing the said correction signal digitally.

2. Circuit in accordance with claim 1, characterized by the fact that the displacement of the characteristic of the said filter from the required frequency is effected by a count of the oscillations of a clock oscillator in a digital phase-detector circuit which detects the response of the said filter with respect to a prefixed reference, the said digital phase detector circuit being realized as a numerical type of phase loop in which the correction signal is memorized in a register.

3. Circuit in accordance with claim 2, characterizeo by the fact that the said digital phase detector circuit is provided with a means of adding a prefixed quantity to (on subtracting a prefixed quantity from) the said correction signal to furnish a frequency off-set for the said voltage controlled filter.

4. Automatic tuning circuit for voltage controlled filters employing a digital control as in the preceding claims and substantially as illustrated and described with reference to Figure 1.

**Jig. 1**

0005128

*Fig. 2*

$\Delta f = 0$

$\Delta f < 0$

$\Delta f > 0$

A) SAWTOOTH

B) DETECTED OUTPUT WITH FILTER TUNED

C) DETECTED OUTPUT WITH FILTER BELOW FREQUENCY

D) DETECTED OUTPUT WITH FILTER ABOVE FREQUENCY